# FASCICULE DE BREVET EUROPEEN

(11) **EP 2 184 788 B1**
(45) Date de publication et mention de la délivrance du brevet: **07.12.2016**
(21) Numéro de dépôt: 09306061.4
(22) Date de dépôt: 06.11.2009
(51) Int. Cl.: H01L 31/107, H01L 31/09

(54) **Photodétecteur à gain interne et détecteur comportant une matrice de tels photodétecteurs**
Photodetektor mit interner Verstärkung und Detektor, der eine Matrix von solchen Photodetektoren enthält
Photodetector with internal gain and detector comprising an array of such photodetectors

(30) Priorité: 10.11.2008 FR 0857612
(43) Date de publication de la demande: 12.05.2010
(73) Titulaire: Commissariat à l'Énergie Atomique et aux Énergies Alternatives, 75015 Paris (FR)
(72) Inventeur: Rothman, Johan, 38250 LANS EN VERCORS (FR); Chamonal, Jean-Paul, 38330 SAINT ISMIER (FR)
(74) Mandataire: Cabinet Laurent & Charras

(56) Documents cités:
- EP-A- 0 553 982
- US-A- 4 481 523
- US-A- 5 059 794
- US-A1- 2008 067 620

## Description

### DOMAINE DE L'INVENTION

L'invention a trait au domaine des photodétecteurs à gain interne.

### ETAT DE LA TECHNIQUE

Un photodétecteur à gain interne est un dispositif qui détecte un rayonnement électromagnétique et génère un signal électrique, ledit signal étant amplifié avant que celui-ci ne soit traité par une électronique de proximité utilisée pour transformer, amplifier et/ou numériser le signal produit par le photodétecteur.

L'amplification interne du photodétecteur permet ainsi de réduire l'amplification de l'électronique de proximité qui est usuellement source de bruit. En outre, un photodétecteur à gain interne est à ce jour le seul dispositif capable de détecter rapidement un faible nombre de photons, et en outre le seul dispositif permettant un comptage de photons précis.

Il existe plusieurs types de photodétecteur à gain interne, notamment les détecteurs à photocathode, les dispositifs de couplage de charges à multiplication d'électrons, les photodiodes à avalanche ou encore les multiplicateurs par ionisation par impact à l'état solide.

Dans un détecteur à photocathode, le rayonnement incident génère des électrons sur une photocathode. Les électrons libérés sont ensuite accélérés au travers d'un élément d'amplification. Bien que présentant un bon rapport signal sur bruit, un détecteur à photocathode présente usuellement un encombrement important, est limité dans la gamme de longueurs d'onde détectable, qui est usuellement inférieure à 1,7 micromètre, et présente un faible rendement quantique, généralement inférieur à 50%.

Les dispositifs à couplage de charge à multiplication d'électrons, ou « EMCCD », détectent quant à eux la lumière dans une première matrice CCD, et les charges ainsi générées sont transférées pixel à pixel dans une seconde matrice CCD par l'application d'impulsions répétitives de tension. Chaque charge intégrée dans un pixel de la première matrice CCD est ainsi transféré N fois, et en appliquant une tension suffisamment forte à ladite matrice, les porteurs transférés peuvent subir une interaction dite d'« ionisation par impact », qui crée un paire électron-trou supplémentaire produisant une amplification de gain m. Le gain total de l'amplification est ainsi égal à N x m. Le rendement quantique observé dans les dispositifs EMCCD est généralement élevé pour les longueurs d'onde du visible, mais se dégrade rapidement dans le proche infrarouge. En outre, la sensibilité spectrale de ce type d'appareil est limitée par le matériau utilisé pour les matrices CCD, usuellement du Si, dont le gap correspond à une longueur d'onde de coupure égale à 0,9 micromètre.

Dans les photodiodes à avalanche, ou diode « APD », les photons incidents génèrent des paires électrons-trous dans un semi-conducteur présentant un premier type de conductivité. Les photo-porteurs minoritaires sont ensuite collectés par une jonction p/n soumise à une forte polarisation inverse. Le champ électrique élevé dans la jonction p/n génère alors une avalanche d'ionisation par impact qui amplifie le signal. Les diodes APD sont des détecteurs robustes, compacts, relativement insensibles au champ magnétique et présentant un fort rendement quantique, typiquement de l'ordre de 90%.

Les diodes APD réalisée en Si ou en semi-conducteur du type III-V, comme par exemple les diodes réalisées en InGaAs, fonctionnent à température ambiante, mais ont des performances limitées par la présence d'une ionisation d'impact, qui est à la fois produite par les électrons et les trous. A fort gain, on observe ainsi une forte dégradation du rapport signal sur bruit ainsi qu'une forte dégradation du temps de réponse. Un phénomène de rupture d'avalanche peut également survenir, rendant alors les diodes APD de ce type non linéaire.

Les diodes APD à base deCdₓHg₁₋ₓTe, et présentant un faible gap d'énergie correspondant à des longueurs d'onde de coupure comprises entre 2,2 et 9 micromètres, présentent quant à elles des propriétés proches de l'idéal grâce à une initiation exclusive de l'ionisation par impact par un seul type de photo-porteur, à savoir les électrons. Ainsi, on observe dans les diodes APD de ce type, un gain exponentiel, jusqu'à des gains très importants supérieurs à 5000, et cela pour des tensions de polarisation faibles d'une dizaine de volts, ainsi qu'un très bon rapport signal sur bruit. Le facteur d'excès du bruit (qui est le rapport de l'accroissement du bruit quantique de la photodiode en régime d'avalanche, sur le bruit quantique de la même photodiode, sans avalanche) est ainsi proche de 1.

Toutefois, les diodes APD à base de CdₓHg₁₋ₓTe ayant un faible gap d'énergie, nécessitent d'être refroidies pour conserver un courant d'obscurité suffisamment faible pour ne pas nuire à leur sensibilité.

Pour des gaps d'énergie plus importants, les performances des diodes APD à base de CdₓHg₁₋ₓTe se dégradent pour se rapprocher de celles des diodes APD classiques réalisées en Si ou en semi-conducteur du type III-V.

En outre, les performances des diodes APD à base de CdₓHg₁₋ₓTe présentant un gap d'énergie faible, inférieur à 0,15 eV, se dégradent fortement en raison d'un fort courant d'obscurité induit par l'effet tunnel provoqué par le champ électrique dans la zone de déplétion.

Le document US2008/0067620 décrit une photodiode à base de Cdₓ Hg₁₋ₓTe.

### EXPOSE DE L'INVENTION

Le but de la présente invention est de proposer un photodétecteur à gain interne capable de forts gains d'amplification sous des tensions de polarisation faibles, ayant un bon rapport signal sur bruit, un faible temps de réponse ainsi qu'un faible courant tunnel, et cela pour une large gamme de longueurs d'onde détectées allant jusqu'à 20 micromètres.

A cet effet, l'invention a pour objet un photodétecteur à gain interne défini par les caractéristiques de la revendication 1 et comportant entre autre :
▪ une structure semi-conductrice, dans laquelle des évènements d'ionisation par impact sont créées majoritairement par des porteurs minoritaires ;
▪ un premier et un second contacts de polarisation agencés dans la structure semi-conductrice ;
▪ un moyen définissant dans la structure semi-conductrice une zone de collecte de photons à proximité du premier contact de polarisation ;
▪ une jonction de type P-N formée dans la structure semi-conductrice entre les deux contacts de polarisation et à proximité du second contact de polarisation ; et
▪ un contact de collecte agencé dans la jonction P-N pour collecter le courant dans la jonction P-N.

Par « à proximité », on entend, selon l'invention, le fait que la zone de collecte des photons est plus proche du premier contact de polarisation que du second contact de polarisation, et que la jonction PN est plus proche du second contact de polarisation que du premier contact de polarisation.

Une diode APD classique comprend usuellement au moins deux couches semi-conductrices de conductivités opposées formant une jonction P-N. Lorsque cette jonction est soumise à une polarisation inverse, une zone de déplétion se forme dans le semi-conducteur le moins dopé, typiquement la première couche semi-conductrice. En présence de porteurs minoritaires, une avalanche d'ionisation par impact est ainsi générée, amplifiant de ce fait le signal.

Selon l'invention, la première couche semi-conductrice de la diode APD est modifiée pour qu'une préamplification par ionisation par impact se produise dans celle-ci lorsqu'elle est soumise à un champ électrique au moyen des premier et second contacts de polarisation. Plus particulièrement, une zone de dérive est formée dans la première couche semi-conductrice de la diode APD. La jonction P-N, soumise à sa propre tension par l'intermédiaire du contact de collecte, a ainsi pour fonction première de collecter les porteurs formés dans la structure semi-conductrice. Le cas échéant, lorsque la jonction P-N est également soumise à une forte polarisation inverse, celle-ci réalise également une amplification par avalanche telle que décrite précédemment.

L'amplification de la jonction P-N est alors réalisée sur les porteurs crées dans la structure semi-conductrice, qui sont plus nombreux que les porteurs créés directement par le bombardement des photons du fait de la préamplification.

Le couplage entre la structure semi-conductrice et la diode APD permet ainsi un gain au moins égal au carré du gain d'une diode APD seule. En outre, le courant tunnel dans la structure semi-conductrice est réduit par rapport à une diode APD à gain égal, notamment en raison d'un champ électrique plus faible utilisé pour obtenir ce gain.

Par ailleurs, la pré-amplification dans la structure semi-conductrice réduit la sensibilité du photoconducteur vis-à-vis de la génération d'un courant d'obscurité dans la diode APD. Cette dernière peut ainsi être utilisée avec un gain plus important que les diodes APD classique sans dégradation du rapport signal sur bruit.

Enfin, l'obtention d'un fort gain par ce couplage permet également une détection dans les longueurs d'ondes de 10 à 20 micromètres grâce à la réduction du courant d'obscurité. Le champ électrique local étant en effet plus faible, le courant d'obscurité lié à l'effet tunnel est réduit.

Selon un mode de réalisation particulier de l'invention, la structure semi-conductrice comporte une première couche semi-conductrice d'un premier type de conductivité, la jonction P-N est formée à l'interface avec une zone semi-conductrice d'un second type de conductivité agencée dans la première couche semi-conductrice.

En d'autres termes, la structure semi-conductrice forme une structure horizontale, la jonction P-N formant une structure sensiblement transversale à la structure semi-conductrice, comme par exemple une géométrie tridimensionnelle dont la forme est entre une demi-sphère et un cylindre.

Plus particulièrement, la structure semi-conductrice comporte en outre une seconde couche semi-conductrice insérée dans la première couche semi-conductrice à hauteur de la zone semi-conductrice de la jonction P-N, la seconde couche semi-conductrice présentant une bande interdite inférieure à celle de la première couche. Notamment, la seconde couche semi-conductrice est du même type de conductivité que la première couche semi-conductrice, ou de type de conductivité opposé avec un dopage inférieur à celui de la première couche semi-conductrice.

En d'autres termes, les porteurs minoritaires générés dans la première couche semi-conductrice par les photons incidents vont diffusés et être confinés dans la seconde couche semi-conductrice. Le gain ainsi obtenu par la préamplification dans la structure semi-conductrice et dans la jonction P-N est ainsi comparable à celui obtenu dans une structure homogène avec une bande interdite égale à celle de la deuxième couche semi-conductrice. Par ailleurs, le courant d'obscurité généré lors de la dérive des porteurs dans la structure semi-conductrice et dans la jonction P-N est réduit par rapport à celui dans une structure homogène avec bande interdite égale à celle de la seconde couche semi-conductrice, par la réduction du volume de cette couche. Ce mode de réalisation permet de réduire les tensions de polarisation utilisées pour obtenir un gain suffisant dans un détecteur réalisé pour détecter des photons avec une longueur d'onde courte, entre 0.4-5 micromètres, en minimisant l'augmentation du courant d'obscurité associé avec une composition de Cd plus faible.

Selon un mode de réalisation particulier de l'invention, la structure semi-conductrice comporte une seconde couche semi-conductrice du premier type de conductivité agencée sur la première couche semi-conductrice, la seconde couche présentant une bande interdite supérieure à celle de la première couche semi-conductrice.

En d'autres termes, la jonction P-N, qui est formée dans la couche semi-conductrice de plus grande bande interdite, nécessite une tension de polarisation inverse accrue pour collecter les porteurs minoritaires formés dans la couche semi-conductrice de plus faible bande interdite, formant ainsi une diode commutable. Ainsi, les porteurs minoritaires ne vont pas être collectés par la jonction P-N à faible polarisation. L'instant de collecte des porteurs via la jonction P-N peut être choisi avec précision en augmentant la polarisation. Ce mode de réalisation est particulièrement adapté pour la réalisation de matrices de détection pour l'imagerie.

Selon un mode de réalisation particulier de l'invention (avec une jonction pn commutable), la structure semi-conductrice comporte une première couche semi-conductrice d'un premier type de conductivité, la jonction P-N étant une structure du type MESA agencée au-dessus de la première couche semi-conductrice.

La structure MESA comporte, comme cela est connu en soi, un empilement de couches semi-conductrices. Ceci permet donc de commuter la jonction P-N entre un état aveugle et un état collecteur.

Selon un mode de réalisation particulier de l'invention, le moyen définissant la zone de collecte des photons comporte une plaque opaque agencée sur ou sous la structure semi-conductrice et possédant une ouverture, notamment une plaque opaque formée d'un seul tenant avec le premier contact de polarisation.

Selon un mode de réalisation particulier de l'invention, le moyen définissant la zone de collecte des photons comporte une microlentille convergente agencée sur ou sous la structure semi-conductrice.

Selon un mode de réalisation particulier de l'invention, une jonction P-N à structure du type MESA est agencée au droit de la zone de collecte des photons de la structure semi-conductrice, ce qui permet d'effectuer une remise à zéro du nombre de porteurs présents dans la structure semi-conductrice avant de commencer une nouvelle collecte et amplification de photons.

Selon un mode de réalisation particulier de l'invention, la structure semi-conductrice comprend un alliage de CdₓHg₁₋ₓTe de type P présentant une composition de Cd inférieure à 60% en stoechiométrie.

L'invention a également pour objet un détecteur comportant une matrice de photoconducteurs du type précité.

Selon un mode de réalisation particulier de celui-ci, deux photodétecteurs contigus sur une ligne sont agencés tête-bêche, leurs contacts de polarisation localisés à proximité des zones de collecte des photons étant commun, ce qui permet notamment un gain de place ainsi qu'une simplicité de conception.

L'invention a également pour objet un détecteur comportant :
▪ une structure semi-conductrice, dans laquelle des évènements d'ionisation par impact sont créées majoritairement par des porteurs minoritaires ;
▪ un premier et un second contacts de polarisation agencés dans la structure semi-conductrice le long de deux bords opposés de la structure ;
▪ un moyen définissant dans la couche de matériau semi-conducteur une zone de collecte de photons à proximité du premier contact de polarisation ;
▪ une première matrice de jonctions de type P-N formée dans la structure semi-conductrice entre les deux contacts de polarisation ;
▪ une seconde matrice de jonction de type P-N formant des structures du type MESA ; et
▪ des moyens de définition de zones de collecte de photons sous chaque jonction de type P-N de la première matrice.

### BREVE DESCRIPTION DES FIGURES

La présente invention sera mieux comprise à la lecture de la description qui va suivre, donnée uniquement à titre d'exemple, et faire en relation avec les dessins annexés, dans lesquels des références identiques désignent des éléments identiques ou analogues, et dans lesquels :
- les figures 1 et 2 sont des vues schématiques respectivement en section et de dessus d'un premier mode de réalisation du photodétecteur à gain interne selon l'invention ;
- les figures 3 et 4 sont des vues schématiques respectivement en section et de dessus d'un second mode de réalisation du photodétecteur à gain interne selon l'invention ;
- la figure 5 est une vue schématique en section d'un quatrième mode de réalisation du photodétecteur à gain interne selon l'invention;
- la figure 6 est une vue schématique en section d'un cinquième mode de réalisation du photodétecteur à gain interne selon l'invention ;
- la figure 7 est une vue schématique en section d'un sixième mode de réalisation du photodétecteur à gain interne selon l'invention ;
- la figure 8 est une vue schématique en section d'un septième mode de réalisation du photodétecteur à gain interne selon l'invention ;
- la figure 9 est une vue schématique en section d'un huitième mode de réalisation du photodétecteur à gain interne selon l'invention
- la figure 10 est une vue schématique de dessus d'une barrette de photodétecteurs à gain interne selon l'invention ;
- les figures 11 et 12 sont des vues schématiques respectivement en section et de dessus d'un premier mode de réalisation d'une matrice de photodétecteurs à gain interne selon l'invention ;
- la figure 13 est une vue schématique de dessus d'un deuxième mode de réalisation d'une matrice de photodétecteurs à gain interne selon l'invention.

### DESCRIPTION DETAILLEE DE L'INVENTION

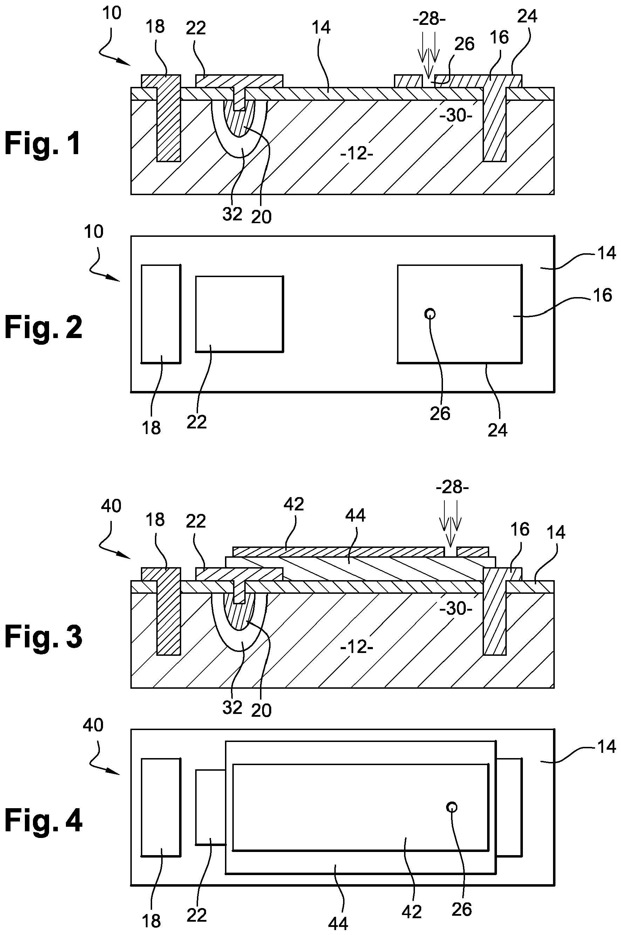

Les figures 1 et 2 illustrent de manière schématique un photodétecteur à gain interne **10** selon un premier mode de réalisation.

Le photodétecteur **10** comporte une couche semi-conductrice **12** d'un premier type de conductivité, par exemple de type P, et une couche de passivation **14,** par exemple en sulfure de zinc (ZnS), recouvrant la couche **12** et protégeant celle-ci contre des dégradations chimiques, mécaniques et électriques. Deux contacts **16, 18** métalliques, et de préférence ohmiques tel que de l'or par exemple, sont par ailleurs prévus dans la couche **12,** traversent la couche de passivation **14** et affleurent à la surface de celle-ci.

La couche **12** est réalisée en un matériau semi-conducteur dopé avec des porteurs majoritaires proches qui ne produisent pas des évènements d'ionisation par impact. Ainsi, lorsque cette couche est soumise à un champ électrique, seuls les porteurs minoritaires, des électrons dans le cas d'une conductivité de type P, génèrent des évènements d'ionisation par impact. Un alliage CdₓHg₁₋ₓTe avec une composition de Cd inférieure à 60% en stoechiométrie (x < 0.6) permet d'obtenir une telle caractéristique.

Une zone **20** de conductivité opposée à celle de la couche semi-conductrice **12,** par exemple constituée d'un matériau du groupe III tel que le bore, est par ailleurs agencée dans celle-ci entre les deux contacts de polarisation **16** et **18,** et un contact métallique de collecte **24** est agencé dans la zone **20** au travers de la couche de passivation **14.**

Un des contacts de polarisation, par exemple le contact **16,** forme à la surface de la couche de passivation **14** une plaque opaque **24** pourvue d'une ouverture **26,** prévue pour laisser passer des photons d'un rayonnement électromagnétique **28** incident, définissant ainsi dans la couche semi-conductrice **12** une zone **30** de collecte de photons à proximité du contact **16.** Définir une zone précise de collecte de photons permet également de réduire la génération d'un photo-courant parasite qui serait sinon produit dans d'autres zones de la couche **12.** La zone **20** est quant à elle formée à proximité de l'autre contact de polarisation **18.**

Dans un mode de fonctionnement continu, une différence de potentiel continue est appliquée entre les contacts de polarisation **16** et **18,** résultant en la création d'un champ électrique « E₁ ». Les photons incidents sur la plaque **24** créent alors des porteurs de charge dans la zone **30.** En présence du champ électrique « E₁ », les porteurs minoritaires migrent vers le contact **18** et génèrent pendant cette migration des évènements d'ionisation par impact, qui multiplient leur nombre, nombre d'autant plus important que la longueur de la couche semi-conductrice entre les deux contacts de polarisation **16** et **18** est importante.

Par ailleurs, la jonction P-N, formée par la combinaison de la zone **20** et de la couche semi-conductrice **12,** est soumise à une forte tension inverse par application d'une tension appropriée sur le contact de collecte **22,** de sorte qu'une zone de déplétion **32,** caractérisée par un fort champ électrique, est crée dans le semi-conducteur le moins dopé, par exemple la couche **12.** Une amplification par avalanche est ainsi obtenue par la jonction P-N se comportant comme une diode APD. De préférence, la zone de déplétion **32** est stabilisée dans une zone de faible dopage, qui peut être formé pendant la réalisation de la zone **20.** La formation cette zone de faible dopage permet de stabiliser le gain de la diode APD. En effet, le gain d'une diode APD dépend de la largeur de sa jonction. En présence d'une zone de faible dopage, la zone de déplétion reste essentiellement dans cette zone, ce qui a pour effet d'insensibiliser le gain vis-à-vis du dopage. Ce gain est ainsi reproductible et le courant d'obscurité plus faible. Par exemple, cette zone est obtenue par implantation d'un élément du groupe III dans le semi-conducteur CdHgTe avec un dopage de type P.

La taille de la jonction P-N formant diode de collecte des porteurs minoritaires est inférieure à 10 micromètres en diamètre, et la longueur de la zone de dérive des porteurs minoritaires, c'est-à-dire l'espacement séparant la zone **30** de collecte des photons de la jonction P-N, est comprise entre 10 micromètres et 1 millimètre.

La distance séparant la jonction P-N du contact de polarisation **18** est faible par rapport à la longueur de la zone de dérive, et est par exemple comprise entre 5 et 20 micromètres. De même la distance séparant la zone de collecte des photons du contact **16** est faible par rapport à la longueur de la zone de dérive, et est par exemple comprise entre 1 et 20 micromètres. Par ailleurs le diamètre de la zone de collecte **30** est faible par rapport à la longueur de la zone de dérive, et est par exemple comprise entre 1 et 20 micromètres.

Le gain total du photodétecteur **10** est ainsi égal à Mₜₒₜₐₗ = M_{D} × M_{APD} × η_{coll} où :
▪ M_{D} est le gain de la pré-amplification obtenue dans la couche **12,**
▪ M_{APD} est le gain obtenu dans la jonction P-N,
▪ et η_{coll} est l'efficacité de collecte des porteurs minoritaires par la jonction P-N.

Un gain supérieur à 2,5×10⁷ est ainsi obtenu dans les détecteurs avec une longueur de coupure proche de 5 micromètres à une température de fonctionnement de T=77K.

Grâce à l'agencement ainsi décrit, il est possible d'obtenir un courant de 1,2 mA pour la détection d'un seul photon incident dans la zone **30,** en supposant une efficacité de collecte η_{coll} modérée égale à 50%, un temps de réponse de l'ordre de 100ps et un gain de Mₜₒₜ=2x10⁶, obtenant ainsi une tension de l'ordre 64mV à l'entrée d'une électronique de proximité avec une impédance d'entrée égale à 50 ohms. Ce signal est directement mesurable sur un oscilloscope rapide.

On notera qu'en fonction de la tension inverse appliquée à la jonction P-N via le contact de collecte **22,** la jonction P-N peut être utilisée soit en mode passif, auquel cas l'amplification de signal est essentiellement réalisée dans la couche **12** puisqu'aucun effet avalanche ne se produit, soit en mode avalanche avec le gain supplémentaire M_{APD}.

Dans un mode de fonctionnement dit « d'intégration », la tension, et donc le champ électrique, entre les contacts de polarisation **16, 18** est dans un premier temps nulle. Les photons incidents dans la zone **30** de la couche semi-conductrice **12** créent ainsi une concentration de porteurs dans cette zone, concentration élargie par diffusion. Dans un deuxième temps, une tension est appliquée entre les contacts **16, 18,** créant ainsi un champ électrique dans la couche **12.** Les porteurs vont alors dériver vers la jonction P-N, soumise à une polarisation inverse, en créant des évènements d'ionisation par impact. Ce mode de fonctionnement est ainsi particulièrement adapté à l'imagerie avec une matrice de détecteur.

Les figures 3 et 4 illustrent un deuxième mode de réalisation de l'invention. A la différence du photodétecteur **10** décrit précédemment, dans le photodétecteur **40** selon le deuxième mode de réalisation, la plaque métallique **24** est remplacée par une métallisation opaque **42,** par exemple en or (Au) déposée sur une couche **44,** par exemple de passivation en sulfure de zinc (ZnS),ou en matériau isolant elle-même déposée sur la couche de passivation **14** et au moins partiellement sur les contacts **16** et **22.** La métallisation opaque **42** s'étend ainsi sensiblement entre ces deux contacts **16, 22,** c'est-à-dire entre la zone de collecte des photons **30** et la jonction P-N de collecte des porteurs minoritaires formée dans la couche **12.** Un meilleur écrantage des photons parasites est ainsi obtenu. En outre, la surface du contact de polarisation **16** est réduite, diminuant ainsi la perturbation du transport des porteurs minoritaires.

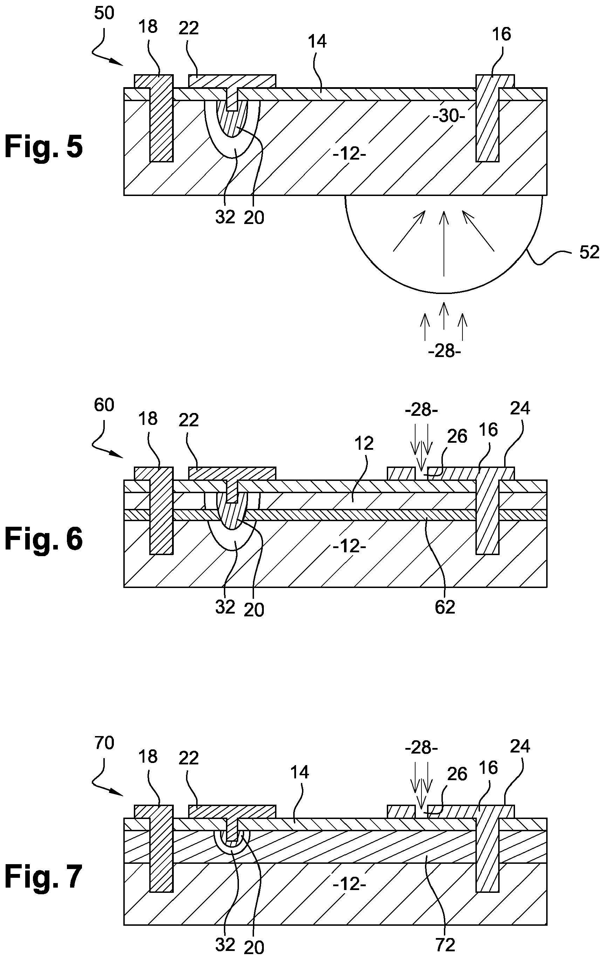

La figure 5 illustre schématiquement une vue en section d'un troisième mode de réalisation, dans lequel le photodétecteur **50** est éclairé par l'arrière par le rayonnement électromagnétique **28,** et est pourvu d'une microlentille **52** focalisant le rayonnement **28** sur la zone **30** de collecte de photons. La surface du contact de polarisation **16** est par ailleurs réduite pour les raisons évoquées précédemment. Il est à noter que la lentille est positionnée sur la face arrière de la couche **12,** de préférence, en regard du contact **16.** Ce positionnement permet de concentrer l'absorption de la lumière au voisinage du contact **16.**

La figure 6 illustre schématiquement une vue en section d'un quatrième mode de réalisation de l'invention. Ce mode de réalisation diffère des modes de réalisation précédents en ce qu'une couche semi-conductrice **62** est insérée dans la couche semi-conductrice **12** à hauteur de la zone **20** de la jonction P-N. Cette couche **62** est soit de même type de conductivité que la couche **12,** par exemple de type p, soit de type opposé avec un dopage inférieur, et présente une bande interdite inférieure à celle de la couche **12.** De cette manière les porteurs minoritaires générés par les photons incidents dans la zone **30** de la couche **12** diffusent et sont confinés dans la couche **62.** La couche semi-conductrice **62** est de préférence constituée de CdₓHg₁₋ₓTe avec une composition de x moins importante que la composition de x de la couche **12.** Par exemple :
- pour la couche **12 :** x est compris entre 0,3 et 0, 8 et le dopage P est réalisé avec une concentration d'arsenic (As) comprise entre 10¹⁵ et 10¹⁷cm⁻³; et
- pour la couche **62 :** x est compris entre 0,15 et 0,4 et le dopage N est réalisé avec une concentration d'indium (In) comprise entre 10¹⁴ et 10¹⁵cm⁻³

Ainsi, le gain obtenu par la dérive des porteurs minoritaires vers la zone **20** est par l'effet avalanche dans la jonction P-N comparable à celui d'une structure homogène, c'est-à-dire constituée d'une unique couche semi-conductrice, avec une bande interdite égale à celle de la couche **62.** Par ailleurs, les courants d'obscurité sont réduits. De préférence, l'épaisseur de la couche **62** est inférieure à celle de la couche **12.** Ainsi, le courant d'obscurité généré lors de la dérive des porteurs dans la structure semi-conductrice et dans la jonction P-N est réduit par rapport à celui dans une structure homogène avec bande interdite égale à celui de deuxième couche semi-conductrice, par la réduction du volume de cette couche. Ce mode de réalisation permet de réduire les tensions de polarisations utilisé pour obtenir un gain suffisant dans un détecteur réalisé pour détecter des photons avec une longueur d'onde courte, entre 0.4-5 micromètres, en minimisant l'augmentation du courant d'obscurité associé avec une composition de Cd plus faible.

La figure 7 illustre schématiquement une vue en section d'un cinquième mode de réalisation de l'invention. Ce mode de réalisation diffère des modes de réalisation des figures 1 à 5 en ce qu'une couche semi-conductrice **72,** de même type de conductivité que la couche **12,** mais avec une bande interdite plus grande que celle de la couche **12,** est insérée entre celle-ci et la couche de passivation **14.** La couche **72** présente par ailleurs une épaisseur suffisante pour que la zone de déplétion **32** se forme intégralement dans celle-ci à faible valeur de polarisation inverse et à travers celle-ci pour des valeurs plus importantes de la polarisation inverse. L'épaisseur de la couche **72** dépend du type de dopage et est de préférence comprise entre 0,5μm et 1 μm de plus que la profondeur de la zone **20.** Préférentiellement, la couche **72** est constituée de CdₓHg₁₋ₓTe avec une composition de x plus importante que la composition de x de la couche **12.** Par exemple, la couche **12** a une composition de x comprise entre 0,15 et 0,4, préférentiellement une composition de x égale à 0,3 et la couche **72** a une composition de x comprise entre 0,2 et 0,5, préférentiellement une composition de x égale à 0,35.

Il est à noter que la zone **32** dépasse dans la couche **12** qu'à forte polarisation inverse. La zone **20** est quant à elle toujours limitée à la couche **72.**

La jonction P-N est ainsi formée par la combinaison de la zone **20** et de la couche **72.** La couche **72** ayant une bande interdite plus élevée, il est donc nécessaire d'appliquer une tension de polarisation inverse à la jonction P-N plus importante pour collecter les porteurs minoritaires. La polarisation inverse étant plus élevée, il est alors plus facile de choisir l'instant de collecte des charges sous la jonction P-N.

On notera que les modes de réalisation des figures 6 et 7 reprennent, hormis la structure semi-conductrice formant avec la jonction P-N avec la zone **20,** l'agencement des modes de réalisation des figures 1 et 2. Bien entendu, l'insertion d'une couche semi-conductrice **62** dans la couche semi-conductrice **12** et l'empilement des couches semi-conductrices **12** et **72** s'appliquent également aux modes de réalisations des figures 3 à 5.

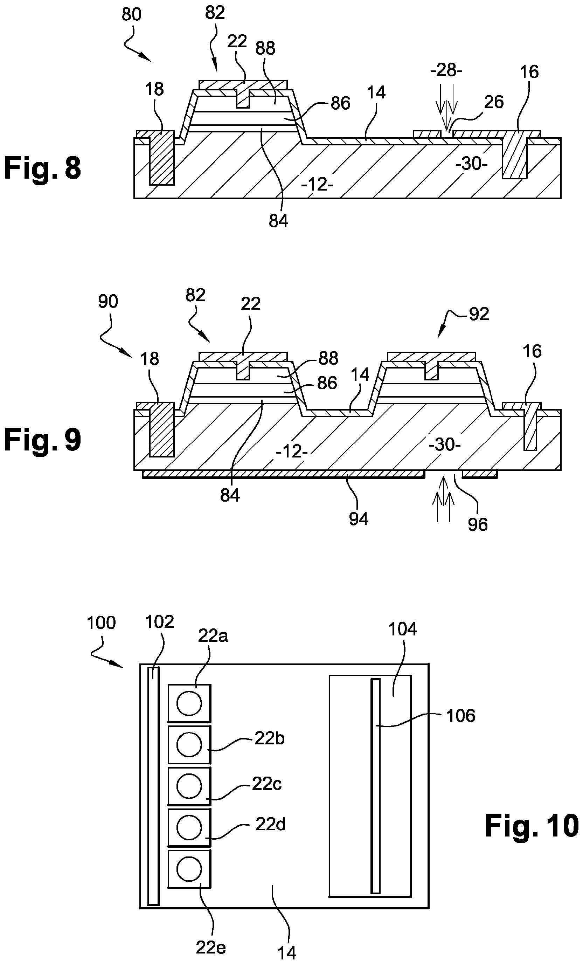

La figure 8 illustre schématiquement une vue en section d'un sixième mode de réalisation de l'invention. Selon ce mode de réalisation, la jonction P-N formant diode des modes de réalisation précédents est remplacée par une jonction P-N formant diode selon une structure **82** dite « MESA » (acronyme de l'expression anglo-saxonne MESA de l'origine espagnole (table) qui signifie un micro-pilier). La structure MESA **82** comporte une première couche **84,** formée sur la couche semi-conductrice **12,** de même type de conductivité et de même bande interdite que celle-ci mais avec un dopage inférieur. Une deuxième couche semi-conductrice **86** est déposée sur la couche **84** et présente la même conductivité et le même dopage que la couche **84** mais avec une bande interdite plus grande. Une troisième couche semi-conductrice **88** déposée sur la couche **86** complète la structure MESA **82,** cette troisième couche **88** présentant un type de conductivité opposée à celle de la couche **86** et une bande interdite identique à celle-ci. La couche de passivation **14** recouvre alors la couche **88** et le contact de collecte **22** est agencé dans celle-ci. Les couches **84, 86** et **88** sont constituées de CdₓHg₁₋ₓTe avec des compositions de Cd qui permettent de réaliser la variation de la bande interdite décrite ci-dessus. Par exemple :
- pour la couche **84 :** x = 0,3, et le dopage P est réalisé avec une concentration d'arsenic comprise entre 10¹⁵ et 5.10¹⁵cm⁻³;
- pour la couche **86 :** x = 0,35, et le dopage P est réalisé avec une concentration d'arsenic comprise entre 10¹⁵ et 5.10¹⁵cm⁻³; et
- pour la couche **88:** x = 0,35, et le dopage N est réalisé avec une concentration d'indium égale à 10¹⁷cm⁻³.

Grâce à une telle structure de diode MESA, il est ainsi obtenu une diode commutable qui permet de choisir l'instant de collecte des porteurs, comme pour le cinquième mode de réalisation. Le mode de réalisation MESA peut apporter un meilleur contrôle de la polarisation de commutation (car on peut la concevoir en choisissant le dopage et l'épaisseur des différentes couches), et ainsi une commutation plus fiable et moins dispersée.

Sur la figure 9, un photoconducteur **90** selon un septième mode de réalisation de l'invention diffère du mode de réalisation de la figure 8 en ce qu'une diode de structure MESA **92,** identique à la structure MESA **82,** est agencée au dessus de la zone **30** de collecte de photons. La zone **30** de collecte est ici définie par une plaque métallique opaque **94,** munie d'une ouverture **96** et rapportée sur la face arrière de la couche semi-conductrice **12.** La plaque est par exemple réalisé en or (Au) avec une épaisseur de 200nm. Le rôle de la plaque opaque 94 et de l'ouverture est de définir l'endroit de pénétration des photons, toute en empêchant une génération ailleurs.

Ainsi, quand la diode de structure MESA **92** est polarisée en inverse, elle collecte les porteurs minoritaires de la zone **30.** Dans le mode de fonctionnement dit « d'intégration », cela permet donc une remise à zéro du nombre de porteurs présents dans le photoconducteur **90** avant de commencer un nouveau cycle d'intégration.

Bien entendu, une diode de structure MESA **92** est applicable à tous les modes de réalisation décrits précédemment, sous couvert de modifications à la portée de l'homme du métier.

La figure 10 illustre une vue schématique de dessus d'une barrette **100** de photodétecteurs selon le premier mode de réalisation des figures 1 et 2, ici une barrette de cinq photodétecteurs. De manière avantageuse, plutôt que de juxtaposer des photodétecteurs distincts pour former la barrette **100,** les contacts de polarisation **102, 104** sont communs à tous les photodétecteurs. Dans l'exemple illustré ici, une fente **106** formée dans le contact de polarisation **104** permet de définir une zone continue de collecte de photons dans la structure semi-conductrice formée sous la couche de passivation **14.** Seules les jonctions P-N, dont sont visibles les contacts de collecte **22a-22e,** sont ici distinctes pour former les points élémentaires de détection de la barrette **100.** Un gain de compacité et de simplicité de fabrication est ainsi obtenu.

La barrette **100** peut ainsi être utilisée dans des applications de spectroscopie ou d'imagerie de type push-broom.

Bien que la barrette **100** illustrée ici se fonde sur le mode de réalisation des figures 1 et 2, on comprendra qu'elle peut être constituée de photodétecteurs selon d'autres modes de réalisation ayant des contacts de polarisation communs. La zone de collecte des photons peut ainsi être définie par une optique externe, des microlentilles rapportée sur la barrette, des antennes plasmoniques et/ou une métallisation rapportée sur la face avant ou arrière de la barrette.

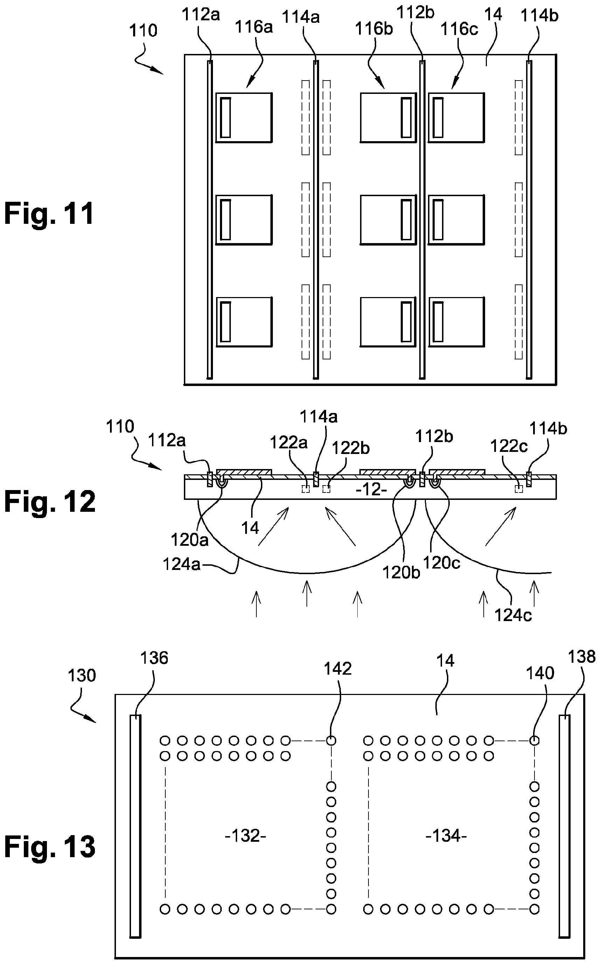

Les figures 11 et 12 illustrent respectivement une vue schématique de dessus et en section d'une matrice **110** de photodétecteurs entrant dans la constitution d'un détecteur matriciel, ici une matrice de 3*3 photodétecteurs.

La matrice **110** comporte une couche semi-conductrice **12** recouverte d'une couche de passivation **14,** comme cela a été décrit précédemment. Des contacts métalliques de polarisation **112a, 112b, 114a, 114b** sont formés dans la couche semi-conductrice **12** au travers de la couche de passivation **14,** et des colonnes **116a, 116b, 116c** de jonctions P-N sont formées entre chaque paire de contacts métalliques adjacents **112a, 112b, 114a, 114b.**

Afin de maximiser le gain, les zones **120a, 120b, 120c** semi-conductrices de type de conductivité opposée à celle de la couche **12,** formant avec celle-ci les jonctions P-N, sont réalisées au plus proche des contacts métalliques **112a, 112b.** De même, les zones de collectes des photons **122a, 122b, 122c** sont définies au plus proche des contacts métalliques **114a, 114b** au moyen de micro lentilles demi-cylindriques **124a, 124b** rapportées sur la face arrière de la matrice **110** et centrées sur les contacts **114a, 114b.**

La zone de collecte des photons peut aussi être définie par d'autre éléments d'optique externe, tel que des microlentilles, des antennes plasmoniques et/ou une métallisation rapportée sur la face avant ou arrière.

La combinaison de deux contacts de polarisation adjacents et d'une jonction P-N définit ainsi un photodétecteur selon l'invention, deux photodétecteurs adjacents sur une ligne de la matrice **110** étant agencés en tête-bêche, c'est-à-dire que leurs jonctions P-N et leurs zones de collectes de photons sont inversées. Trois contacts de polarisation adjacents servent alors à créer un champ électrique dans deux photodétecteurs adjacents sur une ligne.

La matrice **110** permet donc de collecter les porteurs produits par les photons incidents pendant toute la durée d'application de tension de polarisation sur les contacts de polarisation **112a, 112b, 114a, 114b.** Par ailleurs, les signaux générés par les jonctions P-N peuvent être intégrés au moyen d'un circuit de lecture hybridé sur celles-ci.

Bien entendu, des jonctions P-N formant diode du type MESA peuvent être utilisées. De même des diodes de structure MESA peuvent également être utilisées pour les remises à zéro des porteurs minoritaires dans chaque zone de collecte de photons, comme cela a été décrit précédemment. Les photons sont dans ce cas incidents sur la face arrière de la matrice **110.**

La figure 13 est une vue schématique de dessus d'un autre mode de réalisation d'un détecteur matriciel **130** selon l'invention.

Selon ce mode de réalisation, le détecteur **130** comporte deux matrices **132, 134** de jonctions P-N formant des diodes de structures MESA, formées de manière analogue aux modes de réalisation décrits aux figures 8 et 9.

Deux contacts de polarisation **136, 138** sont par ailleurs prévus de part et d'autre du détecteur **130** pour créer un champ électrique dans les matrices **132, 134.** Les zones de collecte de photons sont définies sous chaque diode de structure MESA de la matrice **134,** par exemple au moyen de microlentilles rapportées sous la face arrière du détecteur **130.**

Après une remise à zéro du nombre de porteurs minoritaires sous chaque diode MESA de la matrice **134,** une exposition de la face arrière de celle-ci est réalisée pendant une durée inférieure à la durée de vie des porteurs minoritaires. Une tension est ensuite appliquée aux contacts **136, 138,** créant ainsi dans le détecteur un champ électrique. Les porteurs minoritaires sont alors amplifiés et transférés sous la matrice de diodes MESA **132** et sont collectés par celle-ci.

La durée d'application de la tension sur les contacts **136, 138** est adaptée pour transférer de manière reproductible les porteurs minoritaires produits par des photons incidents sous une diode MESA de la matrice **134** vers une diode MESA de la matrice **132.** Les diodes des matrices **132** et **134** sont ainsi appariées, la diode **140** de la matrice **134** étant par exemple appariée à la diode **142** de la matrice **132.** Connaissant par exemple l'espacement entre les diodes appariées des deux matrices et la vitesse de dérive des porteurs minoritaires en fonction du champ électrique, la tension aux contacts de polarisation et la durée d'application de celle-ci sont connues.

## Revendications

1. Photodétecteur à gain interne (10 ; 40 ; 50 ; 60 ; 70 ; 80 ; 90) comportant :
▪ une structure semi-conductrice (12 ; 12, 62 ; 12, 72), dans laquelle des évènements d'ionisation par impact sont créées majoritairement par des porteurs minoritaires ;
▪ un moyen (24, 26 ; 52 ; 94, 96) définissant dans la structure semi-conductrice une zone de collecte de photons (30) ;
▪ une jonction de type P-N (12, 20 ; 82), formée dans la structure semi-conductrice, ladite jonction étant apte à collecter des porteurs minoritaires de la structure semi-conductrice (12 ; 12, 62 ; 12, 72) et à produire une amplification par avalanche des porteurs minoritaires collectés lorsqu'elle est soumise à une forte polarisation inverse ;
▪ un contact de collecte (22) agencé dans la jonction P-N pour collecter le courant dans la jonction de type P-N ; et
▪ un premier et un second contacts de polarisation (16, 18), agencés dans la structure semi-conductrice (12 ; 12, 62 ; 12, 72) respectivement à proximité de la zone de collecte (30) et de la jonction de type P-N (12, 20 ; 82), la zone de collecte (30) et la jonction de type P-N (12, 20 ; 82) étant entre les premier et second contacts (16, 18), de sorte qu'un champ électrique créé dans la structure semi-conductrice (12 ; 12, 62 ; 12, 72) par une différence de potentiel appliquée entre les premier et second contact (16, 18) produit une pré-amplification par ionisation par impact des porteurs minoritaires créés dans la zone de collecte (30) lors de leur migration vers la jonction de type P-N (12, 20 ; 82) pour leur collecte par celle-ci.

2. Photodétecteur selon la revendication 1, dans lequel la structure semi-conductrice (12 ; 12, 62 ; 12, 72) comporte une première couche semi-conductrice (12) d'un premier type de conductivité, la jonction P-N comportant une zone semi-conductrice (20) d'un second type de conductivité agencée dans la première couche semi-conductrice (12).

3. Photodétecteur selon la revendication 2, dans lequel la structure semi-conductrice (12 ; 12, 62) comporte en outre une seconde couche semi-conductrice (62) insérée dans la première couche semi-conductrice (12) à hauteur de la zone semi-conductrice de la jonction P-N (20), la seconde couche semi-conductrice (62) présentant une bande interdite inférieure à celle de la première couche.

4. Photodétecteur selon la revendication 3, dans lequel la seconde couche semi-conductrice (62) est du même type de conductivité que la première couche semi-conductrice (12), ou de type de conductivité opposé avec un dopage inférieur à celui de la première couche semi-conductrice (12).

5. Photodétecteur selon la revendication 1, dans lequel la structure semi-conductrice (12 ; 12, 62 ; 12, 72) comporte une première couche semi-conductrice (12) d'un premier type de conductivité, la jonction P-N (82) étant une structure du type MESA agencée au-dessus de la première couche semi-conductrice (12).

6. Photodéteccteur selon la revendication 2 ou 5, dans lequel la structure semi-conductrice (12, 72) comporte une seconde couche semi-conductrice (72) du premier type de conductivité agencée sur la première couche semi-conductrice (12), la seconde couche (72) présentant une bande interdite supérieure à celle de la première couche semi-conductrice (12).

7. Photodétecteur selon l'une quelconque des revendications précédentes, dans lequel le moyen (24, 26 ; 52 ; 94, 96) définissant la zone de collecte des photons (30) comporte une plaque opaque (24 ; 94) agencée sur ou sous la structure semi-conductrice et possédant une ouverture (26, 96), notamment une plaque opaque (24) formée d'un seul tenant avec le premier contact de polarisation (16).

8. Photodétecteur selon l'une quelconque des revendications 1 à 7, dans lequel le moyen (24, 26 ; 52 ; 94, 96) définissant la zone de collecte des photons comporte une microlentille convergente (52) agencée sur ou sous la structure semi-conductrice.

9. Photodétecteur selon l'une quelconque des revendications précédentes, dans lequel une jonction P-N à structure du type MESA (92) est agencée au droit de la zone de collecte des photons (30) de la structure semi-conductrice (12 ; 12, 62 ; 12, 72).

10. Photodétecteur selon l'une quelconque des revendications précédentes, dans lequel la structure semi-conductrice (12 ; 12, 62 ; 12, 72) comprend un alliage de CdₓHg₁₋ₓTe de type P présentant une composition de Cd inférieure à 60% en stoechiométrie.

11. Détecteur (100; 110) comportant une matrice de photodétecteurs selon l'une quelconque des revendications précédentes.

12. Détecteur selon la revendication 11, dans lequel deux photodétecteurs contigus sur une ligne sont agencés en tête-bêche, leurs contacts (112a, 112b, 114a, 114b) de polarisation localisés à proximité des zones de collecte des photons étant commun.

13. Détecteur (130) comportant :
▪ une structure semi-conductrice dans laquelle des évènements d'ionisation par impact sont créées majoritairement par des porteurs minoritaires ;
▪ un moyen définissant dans la couche de matériau semi-conducteur une zone de collecte de photons;
▪ une première matrice (132) de jonctions de type P-N formant des structures de type MESA, formée dans la structure semi-conductrice entre les deux contacts de polarisation ;
▪ une seconde matrice (134) de jonction de type P-N formant des structures du type MESA, chaque jonction étant apte à collecter des porteurs minoritaires de la structure semi-conductrice et à produire une amplification par avalanche des porteurs minoritaires collectés lorsqu'elle est soumise à une forte polarisation inverse ; et
▪ des moyens de définition de zones de collecte de photon sous chaque jonction de type P-N de la seconde matrice (134); et
▪ un premier et un second contacts de polarisation (136, 138) agencés dans la structure semi-conductrice le long de deux bords opposés de la structure et respectivement à proximité de la première matrice (132) de jonctions de type P-N et des zones de collecte, la première matrice (132) de jonctions de type P-N et les zones de collecte étant entre les premier et second contacts (136, 138), de sorte qu'un champ électrique créé dans la structure semi-conductrice par une différence de potentiel appliquée entre les premier et second contacts (132, 134) produit une pré-amplification par ionisation par impact des porteurs minoritaires créés dans les zones de collecte lors de leur migration vers la première matrice (132) de jonctions de type P-N pour leur collecte par celles-ci.

## Patentansprüche

1. Photodetektor mit interner Verstärkung (10; 40; 50; 60; 70; 80; 90), umfassend:
- eine Halbleiter-Struktur (12; 12, 62; 12, 72), in der hauptsächlich durch Minoritätsträger Stoßionisationsereignisse geschaffen werden;
- ein Mittel (24, 26; 52; 94, 96), welches innerhalb der Halbleiter-Struktur eine Photonensammelzone (30) definiert;
- eine Verbindung vom Typ P-N (12, 20; 82), die in der Halbleiter-Struktur gebildet ist, wobei besagte Verbindung geeignet ist, Minoritätsträger der Halbleiter-Struktur zu erheben (12; 12, 62; 12, 72) und eine Lawinenverstärkung der erhobenen Minoritätsträger zu produzieren, wenn sie einer starken umgekehrten Polarisierung unterzogen wird;
- ein Sammelkontakt (22), der in der Verbindung P-N angeordnet ist, um den Strom in der Verbindung vom Typ P-N zu sammeln; und
- einem ersten und einem zweiten Polarisierungskontakt (16, 18), die in der Halbleiter-Struktur (12, 62; 12, 72) angeordnet sind, und zwar jeweils in der Nähe der Sammelzone (30) und der Verbindung vom Typ P-N (12, 20; 82), wo sich die Sammelzone (30) und die Verbindung vom Typ P-N (12, 20; 82) zwischen dem ersten und dem zweiten Kontakt (16, 18) befinden, sodass ein elektrisches, in der Halbleiter-Struktur (12; 12, 62; 12, 72) über eine zwischen dem ersten und zweiten Kontakt (16, 18) beaufschlagte Potenzialdifferenz gebildetes Feld eine Vorverstärkung durch Stoßionisation der in der Sammelzone (30) erzeugten Minoritätsträger produziert, und zwar während ihrer Migration zur Verbindung vom Typ P-N (12, 20; 82), wo sie dann von ihr gesammelt werden.

2. Photodetektor gemäß Anspruch 1, in dem die Halbleiter-Struktur (12; 12, 62; 12, 72) eine erste Halbleiterschicht (12) mit einem ersten Typ Leitfähigkeit umfasst, wo die Verbindung P-N einen Halbleiterbereich (20) eines zweiten Typs Leitfähigkeit umfasst, der in der ersten Halbleiterschicht (12) angeordnet ist.

3. Photodetektor gemäß Anspruch 2, in dem die Halbleiter-Struktur (12; 12, 62) außerdem eine zweite Halbleiterschicht (62) umfasst, die in die erste Halbleiterschicht (12) auf Höhe des Halbleiterbereichs der Verbindung P-N (20) eingefügt ist, wobei die zweite Halbleiterschicht (62) eine kleinere Bandlücke aufweist, als die der ersten Schicht.

4. Photodetektor gemäß Anspruch 3, in dem die zweite Halbleiter-Struktur (62) der gleichen Leitfähigkeitsart ist als die erste Halbleiterschicht (12), oder von der entgegensetzten Leitfähigkeitsart mit einer niedrigeren Dotierung als die der ersten Halbleiterschicht (12).

5. Photodetektor gemäß Anspruch 1, in dem die Halbleiter-Struktur (12; 12, 62; 12, 72) eine erste Halbleiterschicht (12) mit einem ersten Typ Leitfähigkeit umfasst, wobei die Verbindung P-N (82) eine Struktur des Typs MESA ist und über der ersten Halbleiterschicht (12) angeordnet ist.

6. Photodetektor gemäß Anspruch 2 oder 5, in dem die Halbleiter-Struktur (12, 72) eine zweite Halbleiterschicht (72) der ersten Art Leitfähigkeit umfasst, die auf der ersten Halbleiterschicht (12) angeordnet ist, und wo die zweite Schicht (72) eine höhere Bandlücke als die der ersten Halbleiterschicht (12) aufweist.

7. Photodetektor gemäß einem der vorstehenden Ansprüche, in dem das Mittel (24, 26; 52; 94, 96), welches die Sammelzone der Photonen (30) definiert eine opake Platte (24; 94) umfasst, die auf oder unter der Halbleiter-Struktur angeordnet ist und eine Öffnung (26, 96), insbesondere eine opake Platte (24), aufweist, die aus einem Stück mit dem ersten Polarisierungskontakt (16) gebildet ist.

8. Photodetektor gemäß einem der vorstehenden Ansprüche 1 bis 7, in dem das Mittel (24, 26; 52; 94, 96), welches die Sammelzone der Photonen definiert, eine konvergierende Mikrolinse (52) umfasst, die auf oder unter der Halbleiter-Struktur angeordnet ist.

9. Photodetektor gemäß einem der vorstehenden Ansprüche, indem eine Verbindung P-N einer Struktur vom Typ MESA (92) in der Linie der Sammelzone der Photonen (30) der Halbleiter-Struktur (12; 12, 62; 12, 72) angeordnet ist.

10. Photodetektor gemäß einem der vorstehenden Ansprüche, indem die Halbleiter-Struktur (12; 12, 62; 12, 72) eine CdₓHg₁₋ₓTe-Legierung vom Type P aufweist, die einen Cd-Gehalt aufweist, der stöchiometrisch unter 60% liegt.

11. Detektor (100; 110), umfassend eine Matrix aus Photodetektoren gemäß einem der vorstehenden Ansprüche.

12. Detektor gemäß Anspruch 11, in dem zwei aneinander angrenzende, in einer Linie stehende Photodetektoren entgegengesetzt angeordnet sind, wobei ihre in der Nähe der Photonensammelzonen befindlichen Polarisierungskontakte (112a, 112b, 114a, 114b) gemein sind.

13. Detektor (130), umfassend:
- eine Halbleiter-Struktur, in der hauptsächlich durch Minoritätsträger Stoßionisationsereignisse geschaffen werden;
- ein Mittel, welches innerhalb der Halbleiter-Materialschicht eine Photonensammelzone definiert;
- eine erste Matrix (132) aus Verbindungen vom Typ P-N, welche Strukturen vom Typ MESA bilden, die in der Halbleiter-Struktur zwischen den beiden Polarisierungskontakten gebildet sind;
- eine zweite Matrix (134) aus Verbindungen vom Typ P-N, welche Strukturen vom Typ MESA bilden, wobei jede Verbindung geeignet ist, um Minoritätsträger der Halbleiter-Struktur zu sammeln und eine Lawinenverstärkung der gesammelten Minoritätsträger zu produzieren, wenn sie einer starken umgekehrten Polarisierung unterzogen wird und
- Mittel zur Definition von Photonensammelzonen unter jeder Verbindung vom Typ P-N der zweiten Matrix (134) und
- einem ersten und einem zweiten Polarisierungskontakt (136, 138), die in der Halbleiter-Struktur entlang von zwei entgegengesetzten Kanten der Struktur und respektive in der Nähe der ersten Matrix (132) aus Verbindungen vom Typ P-N und der Sammelzonen angeordnet sind,
wobei die erste Matrix (132) aus Verbindungen vom Typ P-N und die Sammelzonen zwischen dem ersten und dem zweiten Kontakt (136, 138) befindlich ist, sodass ein elektrisches, in der Halbleiter-Struktur durch eine zwischen dem ersten und dem zweiten Kontakt (134, 134)beaufschlagte Potenzialdifferenz gebildetes Feld eine Vor-Verstärkung durch Stoßionisation der in den Sammelbereichen während ihrer Migration zur ersten Matrix (132) der Verbindungen vom Typ P-N geschaffenen und gesammelten Minoritätsträger produziert.

## Claims

1. Photodetector with internal gain (10; 40; 50; 60; 70; 80; 90) comprising:
▪ a semiconductor structure (12; 12, 62; 12, 72) in which impact ionization events are produced mostly by minority charge carriers;
▪ a means (24, 26; 52; 94, 96) of defining, in the semiconductor structure, a photon collection region (30) ;
▪ a P-N type junction (12, 20; 82) formed in the semiconductor structure, said junction being capable to collect the minority charge carriers of the semiconductor structure (12 ; 12, 62 ; 12, 72) and to produce avalanche amplification of the collected minority charge carriers when it is subjected to a high reverse bias;
▪ a collector contact (22) which is located in the P-N junction and used to collect current in the P-N junction.
▪ a first and a second biasing contacts (16, 18) located in the semiconductor structure (12 ; 12, 62 ; 12, 72); respectively close to the collection region (30) and to the P-N type junction (12, 20 ; 82), the collection region (30) and the P-N type junction (12, 20 ; 82) being between the first and the second contacts, so that an electric field created in the semiconductor structure (12; 12, 62; 12, 72) due to a voltage applied between the first and the second contacts (16, 18) produces pre-amplification due to carrier impact ionization created in the collection region (30) when said carriers migrate towards the P-N type junction (12, 20 ; 82) in view of their collection by the latter.

2. Photodetector as claimed in claim 1, wherein semiconductor structure (12; 12, 62; 12, 72) comprises a first semiconductor layer (12) of a first conductivity type with the P-N junction comprising a semiconductor region (20) of a second conductivity type located in the first semiconductor layer (12).

3. Photodetector as claimed in claim 2, wherein semiconductor structure (12; 12, 62) also comprises a second semiconductor layer (62) inserted into first semiconductor layer (12) at the level of the semiconductor region of P-N junction (20), with the second semiconductor layer (62) having a band gap which is smaller than that of the first layer.

4. Photodetector as claimed in claim 3, wherein the second semiconductor layer (62) has the same type of conductivity as the first semiconductor layer (12) or the opposite type of conductivity with less doping than that of the first semiconductor layer (12).

5. Photodetector as claimed in claim 1, wherein semiconductor structure (12; 12, 62; 12, 72) comprises a first semiconductor layer (12) of a first conductivity type with the P-N junction (82) being a mesa type structure located above first semiconductor layer (12).

6. Photodetector as claimed in claim 2 or 5, wherein semiconductor structure (12, 72) comprises a second semiconductor layer (72) of a first conductivity type located on the first semiconductor layer (12) with second layer (72) having a band gap which is larger than that of first semiconductor layer (12).

7. Photodetector as claimed in any of the above claims, wherein means (24, 26; 52; 94, 96) of defining photon collection region (30) comprises an opaque sheet (24; 94) located on or underneath the semiconductor structure and having an opening (26, 96), especially an opaque sheet (24) formed in a single block with first biasing contact (16).

8. Photodetector as claimed in any of claims 1 to 7, wherein means (24, 26; 52; 94, 96) of defining the photon collection region comprises a convergent micro lens (52) located on or underneath the semiconductor structure.

9. Photodetector as claimed in any of the above claims, wherein a P-N junction with a mesa type structure (92) is located opposite photon collection region (30) of semiconductor structure (12 ; 12, 62 ; 12, 72).

10. Photodetector as claimed in any of the above claims wherein semiconductor structure (12 ; 12, 62 ; 12, 72) comprises a P-type CdₓHg₁₋ₓTe alloy having a stoichiometric Cd composition of less than 60%.

11. Detector (100; 110) comprising an array of photodetectors according to any of the above claims.

12. Detector as claimed in claim 11, wherein two contiguous photodetectors on one row are arranged head to toe with their biasing contacts (112a, 112b, 114a, 114b) located close to the photon collection regions being common.

13. Detector (130) comprising:
▪ a semiconductor structure in which impact ionization events are produced mostly by minority charge carriers;
▪ a means defining, in the semiconductor layer, a photon collection region ;
▪ a first array (132) of P-N type junctions forming mesa type structures formed in the semiconductor structure between the two biasing contacts;
▪ a second array (134) of P-N type junctions forming mesa type structures, each junction being capable to collect the minority charge carriers of the semiconductor structure and to produce avalanche amplification of the collected minority charge carriers when it is subjected to a high reverse bias;
▪ means of defining photon collection regions underneath each P-N type junction of the second array (134) ;
▪ a first and a second biasing contacts (136, 138) located in the semiconductor structure along two opposite edges of the structure, respectively close to the first array (132) of P-N type junctions et to the collection regions, the first array (132) of P-N type junctions and the collection regions being between the first and the second contacts (136, 138), so that an electric field created in the semiconductor structure due to a voltage applied between the first and the second contacts (136, 138) produces pre-amplification due to carrier impact ionization created in the collection regions when said carriers migrate towards the first array (132) of P-N type junctions in view of their collection by the latter.
